# EUROPÄISCHE PATENTSCHRIFT

(11) **EP 0 460 598 B1**
(45) Veröffentlichungstag und Bekanntmachung des Hinweises auf die Patenterteilung: **01.03.1995**
(21) Anmeldenummer: 91109099.1
(22) Anmeldetag: 04.06.1991
(51) Int. Cl.: C30B 25/02, C07F 9/22

(54) **Elementorganische Verbindungen zur Verwendung im elektronischen Bereich**
Organic compounds for application in the field of electronics
Composés organiques pour l'utilisation dans le domaine de l'électronique

(30) Priorität: 05.06.1990 DE 4017966
(43) Veröffentlichungstag der Anmeldung: 11.12.1991
(73) Patentinhaber: PPM PURE METALS GMBH, 38685 Langelsheim (DE)
(72) Erfinder: Zimmer, Michael, Dr., W-3400 Göttingen (DE)
(74) Vertreter: Minderop, Ralph H., Dr. rer. nat.

(56) Entgegenhaltungen:
- EP-A- 0 296 257
- EP-A- 0 337 304
- DE-A- 1 287 571
- FR-A- 1 438 745
- BULL. CHEM. SOC. JPN, Band 60, Nr. 4, 1987, Seiten 1564-1566, JP; F. ANDO et al.: "Insertion of ketene and diphenylketene to the pnictogen-heteroatom bonds"
- J. ORGANOMETALLIC CHEMISTRY, Band 299, 1986, Seiten 169-178, Amsterdam, NL; H.SCHUMANN: "Synthese und Spektroskopische Charakterisierung von Cyclopentadienyleisen-Komplexen mit P-N-Liganden des Typs (C6H5)3-nP(NR2)n (n =0-3; R = CH3, C2H5)"
- INORGANICA CHIMICA ACTA, Band 115, Nr. 2, 15. Mai 1986, Seiten 197-201, CH; J.G. STEVENS et al.: "Synthesis and 121Sb Mössbauer study of a number of organoantimony(III) compounds containing antimony-main group V element bonds"
- CHEMICAL ABSTRACTS, Band 114, Nr. 16, 22. April 1991, Seite 714, Zusammenfassung Nr. 154141f, Columbus, Ohio, US; M.H. ZIMMER et al.:"Trisdimethylaminoarsine as arsenic source for the LP-MOVPE of gallium arsenide"
- J. OF CRYSTAL GROWTH, Band 96, Nr. 4, August 1989, Seiten 769-773, Amsterdam, NL; A.C. JONES et al.: "Growth of AlchiGa1-chiAs by MOVPE using a newalkylaluminium precursor"
- CHEMTRONICS, Band 4, Nr. 1, März 1989, Seiten 26-30, Guildford, Surrey, GB; G.T. MUHR et al.: "Recent advances in the development of arsine substitutes for use in metal organic vapour phase epitaxy of GaAs"

## Beschreibung

Die Erfindung betrifft die Verwendung phosphor-, arsen- und anti-monorganischer Verbindungen, weiche Aminogruppen in unterschiedlicher Anzahl enthalten, für die Abscheidung dünner Filme bzw. epitaktischer Schichten aus der Gasphase.

Die Abscheidung solcher Schichten aus III-V-Kombinationen wie Galliumarsenid, Indiumphosphid oder Galliumphosghid kann zur Herstellung von elektrischen, elektronischen, optischen und optoelektronischen Schaltelementen, Lasern und Verbindungshalbleitern verwendet werden, wobei die Abscheidung dieser Schichten aus der Gasphase erfolgt.

Die Eigenschaften dieser Filme sind von den Abscheidungsbedingungen und der chemischen Zusammensetzung des abgeschiedenen Filmes abhängig.

Für die Abscheidung aus der Gasphase kommen alle bekannten Methoden wie die Metal-Organic-Chemical-Vapour-Deposition (MOCVD bzw. MOVPE) -Methode, die Metal-Organic-Molecular-Beam-Epitaxy (MOMBE), die Photo-Metal-Organic-Vapour-Phase (Photo-MOVP)- Methode- (Zersetzung der Substanzen durch UV-Strahlung), die Laser-Chemical-Vapour-Deposition (Laser-CVD) oder die Metal-Organic-Magneton-Sputtering (MOMS) -Methode in Frage.

Vorteile gegenüber anderen Methoden liegen im kontrollierten Schichtenwachstum, genauer Dotierungskontrolle sowie einfacher Handhabung und Produktionsfreundlichkeit aufgrund Normal- und Niederdruckbedingungen.

Bei der MOCVD-Methode werden Verbindungen eingesetzt, die sich unter Abscheidung von GaAs oder InP unterhalb 900° C zersetzen. Über ein Trägergas werden die Komponenten aus ihren Vorratsgefäßen ("bubbler") aufgrund ihres Dampfdruckes in den geheizten Reaktor transportiert, wo die Abscheidung geschieht. Da der Massenfluß des Dampfes gut kontrollierbar ist, können definierte, dünne Schichten gezüchtet werden.

Bislang werden als V-er-Komponenten für die Gasphasenabscheidung vorwiegend Arsin (AsH₃) und Phosphin (PH₃) verwendet. Beides sind Gase; Arsin ist aufgrund seines sehr niedrigen MAK-Wertes und seiner Stabilität gegenüber Sauerstoff und Wasser extrem gefährlich, und Phosphin ist ebenfalls stark toxisch und darüber hinaus selbstentzündlich. Daher sind für die Herstellung, den Transport, die Lagerung und die Anwendung dieser Gase aufwendige Vorsichts- und Sicherheitsmaßnahmen notwendig. Diese Probleme führten zur Entwicklung von flüssigen phosphor- und arsenorganischen Verbindungen RMH₂ und R₂MH (R= Ethyl, Isopropyl, tert.-Butyl, Phenyl und M= P,As; s. US-A-4 988 640), bislang jedoch mit wechselndem Erfolg (z. B. Vorausfälle durch Adduktbildung mit herkömmlichen III-er-Quellen s. Z. Anorg. Chem. 1965).

BULL. CHEM. SOC. JPN, Bd. 60, Nr. 4, 1987, 1564-1566 offenbart Aminoarsine, -wismutine und -stibine der allgemeinen Formel M(NR₂)₃, wobei M= As, Sb, Bi und R= Methyl, Ethyl, Phenyl bedeuten können. Ferner sind Organoantimonverbindungen aus Inorganica Chemica Acta, Bd. 115, Nr. 2, 1986, 197-201 bekannt. In keinem beider Dokumente ist jedoch ein Hinweis auf die Verwendung dieser Verbindungen als Dotierungsmittel oder zur Abscheidung von III/V-Elementkombinationen aus der Gasphase beschrieben.

Aufgabe der vorliegenden Erfindung war es, organische Verbindungen des Phosphors, des Arsens und des Antimons bereitzustellen, die sowohl hinsichtlich ihrer Herstellung als auch ihrer Verwendung vorteilhafter sind.

Gelöst wurde diese Aufgabe durch die Verwendung der elementorganischen Verbindungen der Formel I

R₍₃₋ₘ₎MR'ₘ ,

worin
- m =: 1, 2 oder 3,
- M =: Phosphor, Arsen oder Antimon,
- R =: H, CH₃, C₂H₃, C₂H₅, C₃H₅, C₃H7, i-C₃H₇, C₄H₉, sek-C₄H₉, t-C₄H₉, C₅H₅, C₆H₅,
- R'=: NH₂, N(CH₃)2, N(C₂H₅)2, N(C3H₇)₂, N(i-C₃H₇)₂, N(CF3)₂, N(C₂F₅)₂, N(C₃F₇)₂, N(i-C₃F₇)₂, N(t-C₄F₉)₂ oder solche Fluoralkylamino-Reste, in denen nur ein Teil der Wasserstoffatome durch Fluor ersetzt ist,
bedeuten, zur Abscheidung dieser Elemente oder mit metallorganischen Verbindungen der III. Hauptgruppe des PSE zur Abscheidung von III-V-Kombinationen dieser Elemente aus der Gasphase auf Substrate oder als Dotierstoffe.

Mit Hilfe dieser Verbindungen ist es möglich, mit metallorganischen Verbindungen der III. Hauptgruppe des PSE, vorzugsweise Trimethylgallium und -indium, Filme mit sehr guten Oberflächen (vergleichbar denen mit Arsin) abzuscheiden. Hierbei ist bemerkenswert, daß es nicht zur Adduktbildung (R₃Me>--[MR₃) {Me= III. Hauptgruppe des PSE und M= V. Hauptgruppe des PSE} in der Gasphase kommt, wie es beim Einsatz von RMH₂ zu beobachten ist.

In Formel I bedeutet M vorzugsweise Phosphor oder Arsen
- m: bedeutet vorzugsweise 2 oder 3
- R: bedeutet vorzugsweise H (wenn m = 2)
- R': bedeutet vorzugsweise NH₂, N(CH₃)₂ oder N(CF₃)₂

Für die erfindungsgemäße Verwendung der Verbindungen der Formel I ist wesentlich das Vorhandensein einer oder mehrerer Stickstoff-M (P,As,Sb)-Bindung(en). Aufgrund ihrer hohen Reaktivität ist gewährleistet, daß sie thermisch leicht abspaltbar sind. Weiterhin schirmen die Aminofunktionen das Zentralatom M sterisch soweit ab, daß mit III-er-Quellen der Formel R₃Me keine Adduktbildung in der Gasphase und somit Vorausfälle beim Epitaxieprozeß zu erwarten bzw. zu beobachten sind.

Die Verbindungen der Formel I sind hervorragend für die MOCVD-Epitaxie (bzw. MOVPE-Methode) geeignet, da sie sich bei höheren Temperaturen unter Freisetzung des Zentralatoms zersetzen. Sie sind ebenfalls für die anderen Methoden der Gasphasenabscheidung, wie Photo-MOVP, Laser-CVD, MOMS oder MOMBE geeignet.

Die Verbindungen der Formel I werden z.T. nach bekannten Methoden hergestellt, wie sie in der Literatur beschrieben sind. In allen Fällen wurden die Reaktionen aber entsprechend den besonderen an die Produkte gestellten Anforderungen bezüglich ihrer Reinheit modifiziert.

Sämtliche Operationen werden unter strengstem Luft- und Feuchtigkeitsausschluß in fettfreien Schliffapparaturen durchgeführt. Zum Einsatz kommen ausschließlich getrocknete und aufbereitete inerte Lösungsmittel. Das gilt ebenso auch für alle anderen verwendeten Ausgangsmaterialien.

Alkyl- und Arylgruppen werden mit Hilfe von Alkalimetallorganylen oder Grignard-Verbindungen eingeführt.

Die Aminogruppierungen werden mit sekundärem Amin unter Chlorwasserstoff-Abspaltung oder mit Alkalimetallamiden unter Natriumchlorid-Abspaltung am Zentralatom eingeführt.

Bieim erfindungsgemäßen Verfahren zur Herstellung dünner Filme oder epitaktischer Schichten auf beliebigen Substraten setzt man bei den an sich bekannten Gasphasen-Abscheidungsprozessen von elementorganischen Verbindungen als Ausgangsverbindungen die Aminoverbindungen der Formel I ein. Die Reaktionsbedingungen können analog den aus der Literatur bekannten und dem Fachmann geläufigen Werten gewählt werden.

Zur Herstellung von Verbindungshalbleitern, elektronischen und optoelektronischen Bauteilen können beim erfindungsgemäßen Verfahren während des Abscheidungsprozesses im Reaktor eine oder mehrere gasförmige Verbindungen des Aluminiums, Galliums oder Indiums, z.B. (CH₃)₃Al, (CH₃)Ga oder (CH₃)₃In zusätzlich zugesetzt werden. Eine weitere Variante des erfindungsgemäßen Verfahrens besteht darin, daß man während des Abscheidungsprozesses zusätzlich zu den erfindungsgemäßen elementorganischen Verbindungen der Formel I Dotierstoffe zusetzt. Dabei handelt es sich vor allem um flüchtige metallorganische Verbindungen des Eisens, Magnesiums, Zinks und Chroms.

Ferner ist es möglich, die Verbindungen der Formel I als Dotierstoffe während des Abscheidungsprozesses anderer metallorganischer Verbindungen zuzusetzen.

Die nach dem erfindungsgemäßen Verfahren hergestellten Schichten können für die Herstellung von elektrischen, optischen, elektronischen und optoelektronischen Schaltelementen, Verbindungshalbleitern oder Lasern verwendet werden.

Die folgenden Beispiele sollen die Erfindung näher erläutern. Temperaturangaben erfolgen in Grad Celsius, kp bedeutet Siedepunkt.

### Beispiel 1

Zu 90 g (0,5 mol) hochreinem Arsentrichlorid (7N) in 1 Liter Pentan wird unter starkem Rühren bei - 15 ^{o}C Dimethylamin eingeleitet. Nach Sättigung der Lösung mit Dimethylamin (erkennbar am Absitzen des Niederschlages) bringt man die Reaktionsmischung auf 35 ^{o}C. Durch erneutes Einleiten von Dimethylamin prüft man auf Vollständigkeit der Reaktion. Die Lösung wird über einen Spezialfilter (Porenweite 1) abfiltriert. Das Pentan wird bei Normaldruck abdestilliert, das Produkt anschließend fraktioniert. Man erhält farbloses Tris(dimethylamino)arsin als farblose Flüssigkeit mit kp 57 ^{o}C/1,7.10³ Pa (13 Torr).

Analog werden hergestellt:
Tris(dimethylamino)phosphin
Tris(dimethylamino)stibin
Tris(bis(trifluormethyl)amino)arsin
Tris(bis(trifluormethyl)amino)phosphin
Tris(bis(trifluormethyl)amino)stibin
Tris(bis(heptafluorethyl)amino)arsin
Tris(bis(heptafluorethyl)amino)phospin
Tris(bis(heptafluorethyl)amino)stibin

## Patentansprüche

1. Verwendung der elementorganischen Verbindungen der Formel I
R₍₃₋ₘ₎MR'ₘ ,
worin
m = 1, 2 oder 3,
M = Phosphor, Arsen oder Antimon,
R = H, CH₃, C₂H₃, C₂H₅, C₃H₅, C₃H7, i-C₃H₇, C₄H₉, sek-C₄H₉, t-C₄H₉, C₅H₅, C₆H₅,
R'= NH₂, N(CH₃)2, N(C₂H₅)2, N(C3H₇)₂, N(i-C₃H₇)₂, N(CF3)₂, N(C₂F₅)₂, N(C₃F₇)₂, N(i-C₃F₇)₂, N(t-C₄F₉)₂ oder solche Fluoralkylamino-Reste, in denen nur ein Teil der Wasserstoffatome durch Fluor ersetzt ist,
bedeuten, zur Abscheidung dieser Elemente oder mit metallorganischen Verbindungen der III. Hauptgruppe des PSE zur Abscheidung von III-V-Kombinationen dieser Elemente aus der Gasphase auf Substrate oder als Dotierstoffe.

2. Verwendung nach Anspruch 1 zur Abscheidung epitaktischer Schichten.

3. Verwendung nach Anspruch 1 oder 2, dadurch gekennzeichnet, daß man zusätzlich zu den element-organischen Verbindungen der Formel I während des Abscheidungsprozesses Dotierstoffe zusetzt.

## Claims

1. Use of the element-organic compounds of formula I
R₍₃₋ₘ₎MR'ₘ (I)
where
m = 1, 2 or 3,
M = phosphorus, arsenic or antimony,
R = H, CH₃, C₂H₃, C₂H₅, C₃H₅, C₃H₇, i-C₃H₇, C₄H₉, sec-C₄H₉, t-C₄H₉, C₅H₅, C₆H₅,
R' = NH₂, N(CH₃)2, N(C₂H₅)2, N(C3H₇)₂, N(i-C₃H₇)₂, N (CF3)₂, N(C₂F₅)₂, N(C₃F₇)₂, N(i-C₃F₇)₂, N(t-C₄F₉)₂ or such fluoroalkylamino residues, in which only a part of the hydrogen atoms is replaced by fluorine,
for the precipation of these elements or, with metal-organic compounds of the III main group of the periodic system for the precipitation of III-V-combinations of these elements from the gaseous phase onto substrates or as doping substances.

2. Use according to Claim 1 for the precipitation of epitactic coatings.

3. Use according to Claim 1 or 2, characterized in that additionally to the element-organic compounds of formula I, doping substances are added during the precipitation process.

## Revendications

1. Utilisation de composés organiques d'élément, lesdits composés étant de formule I
R₍₃₋ₘ₎MR'ₘ
dans laquelle
m = 1, 2 ou 3,
M= phosphore, arsenic ou antimoine
R = H, CH₃, C₂H₃, C₂H₅, C₃H₅, C₃H₇, i-C₃H₇, C₄H₉, sec-C₄H₉, t-C₄H₉, C₅H₅, C₆H₅,
R'= NH₂, N(CH₃)₂, N(C₂H₅)₂, n(C₃H₇)₂, N(i-C₃H₇)₂, N(CF₃)₂, N(C₂F₅)₂, N(C₃F₇)₂, N(i-C₃F₇)₂, N(t-C₄F₉)₂
ou pareils radicaux fluoroalkylamino dans lesquels seule une partie des hydrogènes est remplacée par du fluor,
pour le dépôt de ces éléments ou, avec des composés organométalliques du groupe principal III du tableau périodique des éléments, pour le dépôt de combinaisons III-V de ces éléments, à partir d'un phase gazeuse, sur un substrat ou comme agent de dopage.

2. Utilisation selon la revendication 1 pour le dépôt de couches épitaxiales.

3. Utilisation selon n'importe laquelle des revendications 1 et 2 caractérisée en ce qu'en outre, on ajoute aux composés organiques d'élément de formule I, durant le processus de dépôt, un agent dopant.
